# DEMANDE DE BREVET EUROPEEN

(11) **EP 2 107 619 A2**
(43) Date de publication de la demande: **07.10.2009**
(21) Numéro de dépôt: 09156721.4
(22) Date de dépôt: 30.03.2009
(51) Int. Cl.: H01L 31/18, C30B 15/00, H01L 21/322, H01L 21/324, H01L 31/0368

(54) **Procédé de traitement d'un substrat semi-conducteur par activation thermique d'éléments légers**

(30) Priorité: 03.04.2008 FR 0852217
(71) Demandeur: COMMISSARIAT A L'ENERGIE ATOMIQUE, 75015 Paris (FR)
(72) Inventeur: Dubois, Sébastien, 74950 Scionzier (FR); Enjalbert, Nicolas, 38630, Les Avenirs (FR); Monna, Rémi, 38600, Fontaine (FR)
(74) Mandataire: Ilgart, Jean-Christophe

(57) **Abrégé**

Procédé de traitement d'un substrat à base d'un semi-conducteur de type Si_{X}A_{Y} et comportant quatre types distincts d'éléments légers, comprenant les étapes suivantes :
- réalisation d'un premier recuit du substrat à une température T1 correspondant à une température d'activation thermique d'un premier des quatre types d'éléments légers,
- réalisation d'un second recuit à une température T2 correspondant à une température d'activation thermique d'un second des quatre types d'éléments légers,
- réalisation d'un troisième recuit à une température T3 correspondant à une température d'activation thermique d'un troisième des quatre types d'éléments légers,
- réalisation d'un quatrième recuit à une température T4 correspondant à une température d'activation thermique d'un quatrième des quatre types d'éléments légers,

chaque recuit comportant un maintien à la température T1, T2, T3 ou T4 et les températures étant telles que T1 > T2 > T3 > T4.

## Description

### DOMAINE TECHNIQUE

L'invention concerne un procédé de traitement d'un substrat à base de semi-conducteur par activation thermique d'éléments légers présents dans le substrat. L'invention concerne également un procédé de réalisation d'un dispositif semi-conducteur à partir d'un substrat comprenant des éléments légers activés thermiquement. L'invention s'applique particulièrement pour la réalisation de cellules photovoltaïques.

### ÉTAT DE LA TECHNIQUE ANTÉRIEURE

De nombreuses recherches concernent la production de silicium cristallin (monocristallin ou multicristallin) pour la réalisation de substrats, notamment dans le domaine des applications photovoltaïques, à partir de silicium purifié par voie métallurgique ou par voie chimique dégradée. Le silicium obtenu à partir de ces nouvelles sources contient de façon générale des concentrations en impuretés métalliques (par exemple du fer, du chrome, du cuivre, ...), en impuretés dopantes (par exemple du bore, du phosphore, de l'aluminium, ...), et en éléments légers (par exemple de l'oxygène, de l'azote, du carbone, de l'hydrogène, ...) bien plus élevées que dans du silicium de qualité électronique.

Les impuretés métalliques présentes dans ce type de silicium sont généralement éliminées en grande partie lors de la solidification directionnelle du lingot de silicium par ségrégation et, lorsque ce silicium est utilisé pour la réalisation de substrats de cellules photovoltaïques, lors du procédé de fabrication des cellules qui permet l'extraction, par effet getter ou par l'intermédiaire de la passivation via l'hydrogène utilisé, des impuretés métalliques résiduelles. Le document « Electrical parameter changes in silicon solar cells induced by thermal donor formation » de J.M. Ruiz et al, Proceedings of the 21st IEEE Photovoltaic Specialists Conference, Kissimmee, FL, du 21 au 25 mai 1990, Conference Record, Vol. 1, 1990, pages 284 à 288, décrit le piégeage d'impuretés métalliques par effet getter grâce à une étape de recuit à une température égale à environ 450°C.

Bien que cette extraction des impuretés métalliques purifie partiellement ce type de silicium, le rendement d'une telle cellule photovoltaïque reste inférieur au rendement d'une cellule photovoltaïque réalisée avec un substrat de silicium de qualité électronique à cause de la présence de concentrations élevées en impuretés dopantes.

Les impuretés dopantes confèrent au semi-conducteur leur type de conductivité, p ou n. Elles influent sur les propriétés de transport des charges libres (électrons et trous) dans le semi-conducteur. Elles ont aussi une influence directe sur la durée de vie τ des charges libres ainsi que sur leur longueur de diffusion L. Le rendement de conversion énergétique de cellules photovoltaïques fabriquées à partir de semi-conducteur tel que du silicium purifié par voie métallurgique ou par voie chimique dégradée se trouve donc en général limité par cette quantité trop importante d'impuretés dopantes.

De plus, la présence importante d'éléments légers, tel que l'oxygène présent notamment dans du silicium monocristallin élaboré par croissance Czochralski (Cz) ou du silicium multicristallin élaboré à partir de charges de silicium purifiées par voie chimique dégradée ou par voie métallurgique, entraîne également une dégradation importante du rendement des cellules photovoltaïques réalisées à partir de ce silicium, notamment lorsqu'elles se trouvent sous éclairement.

### EXPOSÉ DE L'INVENTION

Un but de la présente invention est de proposer un procédé de traitement d'un substrat à base de semi-conducteur permettant notamment lorsque le substrat est à base d'un semi-conducteur comportant plusieurs types d'éléments légers, comme par exemple du silicium purifié par voie métallurgique ou par voie chimique dégradée, d'améliorer la qualité électrique du semi-conducteur du substrat.

Un but de la présente invention est également de proposer un procédé de réalisation d'un dispositif semi-conducteur, et notamment d'une cellule photovoltaïque, dont la mise en oeuvre permet d'améliorer sensiblement la qualité électrique du semi-conducteur du substrat utilisé, améliorant ainsi les performances du dispositif semi-conducteur, par exemple le rendement de conversion énergétique du dispositif lorsque celui-ci est une cellule photovoltaïque.

Pour cela, la présente invention propose un procédé de traitement d'un substrat à base d'au moins un semi-conducteur comportant au moins quatre types distincts d'éléments légers, comprenant au moins les étapes suivantes :
- réalisation d'un premier recuit du substrat à une température T1 correspondant à une température d'activation thermique d'un premier des quatre types d'éléments légers,
- réalisation d'un second recuit du substrat à une température T2 correspondant à une température d'activation thermique d'un second des quatre types d'éléments légers,
- réalisation d'un troisième recuit du substrat à une température T3 correspondant à une température d'activation thermique d'un troisième des quatre types d'éléments légers,
- réalisation d'un quatrième recuit du substrat à une température T4 correspondant à une température d'activation thermique d'un quatrième des quatre types d'éléments légers,
les températures T1, T2, T3 et T4 étant telles que T1 > T2 > T3 > T4.

La présente invention concerne également un procédé de traitement d'un substrat à base d'au moins un semi-conducteur de type Si_{X}A_{Y}, x étant un nombre strictement positif, y étant un nombre positif et A désignant un élément chimique ou un composé de plusieurs éléments chimiques de la quatorzième colonne du tableau périodique des éléments, et comportant au moins quatre types distincts d'éléments légers, le procédé comprenant au moins les étapes suivantes :
- réalisation d'un premier recuit du substrat à une température T1 correspondant à une température d'activation thermique d'un premier des quatre types d'éléments légers,
- réalisation, après le premier recuit, d'un second recuit du substrat à une température T2 correspondant à une température d'activation thermique d'un second des quatre types d'éléments légers,
- réalisation, après le second recuit, d'un troisième recuit du substrat à une température T3 correspondant à une température d'activation thermique d'un troisième des quatre types d'éléments légers,
- réalisation, après le troisième recuit, d'un quatrième recuit du substrat à une température T4 correspondant à une température d'activation thermique d'un quatrième des quatre types d'éléments légers,
chaque recuit comportant un maintien à la température T1, T2, T3 ou T4 pendant une durée déterminée, et les températures T1, T2, T3 et T4 étant telles que T1 > T2 > T3 > T4.

On entend par « élément léger » un élément comportant un numéro atomique Z inférieur à 18.

De plus, on entend par « composé » un produit constitué par l'union de deux ou plusieurs éléments chimiques dans des proportions de masse définies.

Le substrat est à base d'au moins un semi-conducteur de type Si_{X}A_{Y}, c'est-à-dire à base de silicium et éventuellement à base d'au moins un autre élément de la famille des cristallogènes (éléments de la quatorzième colonne du tableau périodique des éléments).

Ainsi, l'activation thermique des éléments légers présents dans le semi-conducteur du substrat active le caractère donneur d'électrons de ces éléments, c'est-à-dire leur capacité à libérer des électrons dans le semi-conducteur. La température à laquelle est réalisé chacun des recuits correspond à la température à laquelle un type d'éléments légers présents dans le substrat est activé thermiquement.

De plus, étant donné qu'une activation thermique d'un type d'éléments légers peut être « annulée » en réalisant ensuite un autre recuit à une température supérieure au précédent recuit réalisant cette activation, ce procédé, en réalisant plusieurs recuits allant de la température d'activation thermique la plus élevée vers la température d'activation thermique la plus basse, permet une activation successive des différents types de d'éléments légers présents dans le semi-conducteur sans annuler les précédentes activations thermiques réalisées au cours du procédé.

Par exemple, le principal élément léger présent dans le silicium monocristallin élaboré par la méthode de croissance Cz est l'oxygène car celui-ci est initialement présent dans le creuset en silice utilisé pour la croissance des lingots de silicium. Un recuit autour de 450°C permet l'activation thermique de cet élément. Un tel recuit à environ 450°C permet la diffusion de dimères d'oxygènes qui s'associent pour former une espèce à la stoechiométrie plus complexe qui a un comportement donneur d'électrons dans le silicium. Le donneur ainsi formé est stable à température ambiante, mais un recuit à une température voisine ou supérieure à environ 700°C permet sa dissociation, ce qui annulerait les effets de l'activation thermique précédemment réalisée.

De plus, la dégradation sous éclairement du rendement de conversion de cellules photovoltaïques réalisées à partir d'un substrat soumis à ce procédé de traitement est atténuée, en particulier lorsque l'un des donneurs thermiques activés est de l'oxygène. De plus, ce procédé de traitement permet de développer un effet getter dans le substrat, favorable à l'élimination des impuretés métalliques présentes dans le substrat.

Les recuits impliquent que l'on réalise un maintien à température pendant une certaine durée. L'activation thermique présente une cinétique longue : ainsi, les paliers (aux températures T1, T2, T3 ou T4) sont maintenus pendant une durée supérieure ou égale à environ 10 minutes, ou supérieure ou égale à environ 30 minutes, cette durée pouvant également s'étendre sur plusieurs heures.

Le semi-conducteur peut être du silicium cristallin de type p.

Chacun des quatre types d'éléments légers présents dans le semi-conducteur peut être soit de l'oxygène, de l'azote, du carbone, de l'hydrogène, du fluor, du souffre, du chlore, un composé d'azote et d'oxygène, ou d'autres composés entre ces divers éléments.

T1 peut être comprise entre environ 530°C et environ 830°C, et/ou T2 peut être comprise entre environ 450°C et 750°C, et/ou T3 peut être comprise entre environ 350°C et 650°C, et/ou T4 peut être comprise entre environ 300°C et 600°C.

T1 peut être égale à environ 680°C, et/ou T2 peut être égale à environ 600°C, et/ou T3 peut être égale à environ 500°C, et/ou T4 peut être égale à environ 450°C.

Le procédé de traitement peut comporter en outre, après la réalisation du quatrième recuit, la réalisation d'un cinquième recuit à une température T5 correspondant à une température d'activation thermique d'un cinquième type d'éléments légers présents dans le semi-conducteur distinct des quatre autres types d'éléments légers présents dans le semi-conducteur, avec T5 < T4.

Le procédé de traitement peut comporter en outre, après la réalisation du cinquième recuit, la réalisation d'un sixième recuit à une température T6 correspondant à une température d'activation thermique d'un sixième type d'éléments légers présents dans le semi-conducteur distinct des cinq autres types d'éléments légers présents dans le semi-conducteur, avec T6 < T5.

Le procédé de traitement peut comporter en outre, après la réalisation du sixième recuit, la réalisation d'un septième recuit à une température T7 correspondant à une température d'activation thermique d'un septième type d'éléments légers présents dans le semi-conducteur distinct des six autres types d'éléments légers présents dans le semi-conducteur, avec T7 < T6.

Le procédé de traitement peut comporter en outre, après la réalisation du septième recuit, la réalisation d'un huitième recuit à une température T8 correspondant à une température d'activation thermique d'un huitième type d'éléments légers présents dans le semi-conducteur distinct des sept autres types d'éléments légers présents dans le semi-conducteur, avec T8 < T7.

Au moins l'un des recuits peut être réalisé dans un four à lampe dans lequel est disposé le substrat à base de semi-conducteur.

De plus, au moins l'un des recuits peut être réalisé sous atmosphère d'oxygène et/ou d'azote et/ou d'hydrogène et/ou d'argon et/ou d'hélium.

Les recuits peuvent être réalisés sur un lingot du semi-conducteur, le substrat pouvant être ensuite obtenu par une coupe d'une tranche du lingot. Ainsi, il est possible de diminuer le budget thermique utilisé lors de cette étape de découpe.

Le procédé de traitement peut réaliser l'activation thermique des éléments chlore présents dans le substrat par un recuit à une température comprise entre environ 350°C et 1000°C.

Le procédé de traitement peut réaliser l'activation thermique des éléments carbone, dont des donneurs associant des éléments C, N et O se forment lors de recuits entre environ 500°C et 700°C.

Le procédé de traitement peut réaliser l'activation thermique des éléments souffre présents dans le substrat par un recuit à une température comprise entre environ 482°C et 594°C.

Enfin, il est possible de réaliser une activation particulièrement efficace du caractère donneur du fluore présent dans le substrat par un recuit à une température égale à environ 600°C.

L'invention concerne également un procédé de réalisation d'un dispositif semi-conducteur à partir d'un substrat à base d'au moins un semi-conducteur, par exemple de type Si_{X}A_{Y}, x étant un nombre strictement positif, y étant un nombre positif et A désignant un élément chimique ou un composé de plusieurs éléments chimiques de la quatorzième colonne du tableau périodique des éléments, et comportant au moins quatre types distincts d'éléments légers, comportant au moins la mise en oeuvre du procédé de traitement du substrat selon l'invention tel que décrit précédemment.

Dans ce cas, le dispositif semi-conducteur peut comporter au moins une cellule photovoltaïque. En effet, ce procédé de traitement s'applique particulièrement bien au silicium utilisé par l'industrie photovoltaïque car le silicium monocristallin Cz et le silicium multicristallin, que celui-ci soit purifié ou non par voie métallurgique, contiennent des concentrations élevées en éléments légers et notamment en oxygène. Le procédé de traitement permet de neutraliser le pouvoir recombinant de l'espèce dopante présente dans ce silicium, améliorant ainsi les performances des cellules photovoltaïques au silicium cristallin de type p réalisées à partir de substrats ainsi traités.

Lorsque le substrat est à base de silicium cristallin de type p, le procédé de réalisation du dispositif semi-conducteur peut comporter en outre les étapes suivantes :
- texturation d'au moins une première face du substrat destinée à former une face avant de la cellule photovoltaïque,
- formation d'une couche dopée N+ au niveau des faces du substrat,
- dépôt d'une couche de passivation et/ou anti-reflet sur la couche dopée N+, au niveau de la première face du substrat,
- réalisation de contacts conducteurs sur la couche de passivation et/ou anti-reflet et sur la couche dopée N+, au niveau d'une seconde face, opposée à la première face, du substrat,
- recuit des contacts conducteurs,
- gravure de la couche dopée N+ au niveau des faces du substrat sensiblement perpendiculaires à la première et à la seconde face du substrat,
les étapes du procédé de traitement du substrat pouvant être mises en oeuvre avant l'étape de texturation, et/ou après l'étape de gravure, et/ou entre deux étapes du procédé de réalisation du dispositif semi-conducteur.

Ainsi, au cours d'un procédé de réalisation d'une cellule photovoltaïque à homojonction de type p, les recuits d'activation des donneurs thermiques peuvent être réalisés entre deux étapes du procédé de réalisation de la cellule. Les recuits peuvent plus particulièrement être réalisés après l'étape de formation de la couche dopée N+, mise en oeuvre par exemple par diffusion de phosphore dans le substrat, ou après le dépôt de la couche de passivation et/ou anti-reflet, ou après le recuit des contacts conducteurs. De plus, étant donné que le dépôt de la couche de passivation et/ou anti-reflet, par exemple à base de SiN, permet l'introduction d'hydrogène à la surface et dans le volume du substrat, et que l'hydrogène est un catalyseur de la formation des donneurs thermiques, il est particulièrement intéressant de mettre en oeuvre les recuits d'activation thermique après le dépôt de la couche de passivation ou après le recuit des contacts conducteurs.

Dans une variante, lorsque le substrat est à base de silicium cristallin de type p, le procédé de réalisation du dispositif semi-conducteur peut comporter en outre au moins une étape de dépôt d'une couche de silicium amorphe sur deux faces opposées du substrat destinées à former les faces avant et arrière de la cellule photovoltaïque, les étapes du procédé de traitement du substrat pouvant être mises en oeuvre avant cette étape de dépôt.

Au cours d'un procédé de réalisation d'une cellule photovoltaïque à hétérojonctions silicium amorphe - silicium cristallin, les étapes du procédé de réalisation de la cellule peuvent être réalisées à basse température, c'est-à-dire à une température inférieure à environ 400°C. Ainsi, les recuits d'activation thermique des donneurs peuvent être mis en oeuvre avant l'étape de formation des hétérojonctions, ou sur le lingot de silicium ou sur le substrat obtenu après découpe du lingot, avant le début du procédé de réalisation de la cellule photovoltaïque.

L'invention peut également trouver des applications dans des domaines autres que les cellules photovoltaïques, par exemple dans la réalisation de dispositifs optoélectroniques à partir de substrats semi-conducteurs comportant des concentrations importantes en éléments légers.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1F représentent les étapes d'un procédé de réalisation d'une cellule photovoltaïque à homojonction, objet de la présente invention, selon un exemple de réalisation particulier,
- la figure 2 représente l'évolution de la durée de vie des charges libres en fonction du niveau d'injection pour différente valeur de résistivité du silicium, pour un niveau d'énergie situé à 0,1 eV de la bande de conduction,
- la figure 3 représente l'évolution de la longueur de diffusion en fonction du degré de compensation du bore dans du silicium pour une concentration en bore donnée,
- la figure 4 représente une cellule photovoltaïque à hétérojonction réalisée à partir d'un substrat à éléments légers activés thermiquement.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

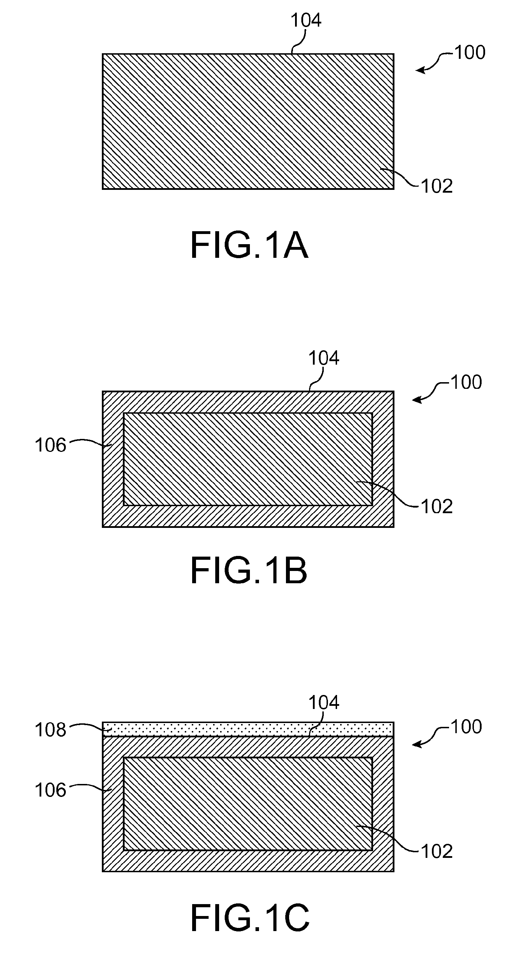

On se réfère tout d'abord aux figures 1A à 1F qui représentent les étapes d'un procédé de réalisation d'une cellule photovoltaïque 100 selon un premier exemple de réalisation.

Comme représenté sur la figure 1A, la cellule photovoltaïque 100 est réalisée à partir d'un substrat 102 à base de semi-conducteur, par exemple du silicium cristallin de type p. Ce silicium, par exemple monocristallin et obtenu par croissance Cz, comporte des concentrations importantes en impuretés dopantes, et notamment en bore. Ces concentrations peuvent par exemple être comprises entre environ 10¹⁵ cm⁻³ et 3.10¹⁸ cm⁻³. De plus, étant donné que ce silicium a été obtenu par croissance Cz, il comporte également une quantité importante d'éléments légers, notamment en oxygène, qui peuvent par exemple être comprises entre environ 10¹⁷ cm⁻³ et 5.10¹⁸ cm⁻³.

Pour la réalisation de la cellule photovoltaïque 100, on réalise tout d'abord une texturation de la face 104 du substrat 102, cette face 104 étant destinée à former la face avant de la cellule photovoltaïque 100, c'est-à-dire la face destinée à recevoir la lumière. Cette texturation peut être obtenue de manière chimique, par exemple à partir d'une solution de KOH appliquée sur la face 104. La texturation de la face 104 permet de réduire la réflectivité de cette face 104, mais également de réaliser un confinement optique dans le substrat 102 des rayons lumineux entrant par cette face 104.

On forme ensuite une couche 106 dopée N+, par exemple par diffusion de phosphore, autour du substrat 102 dopé P. On forme ainsi une jonction PN entre cette couche 106 et le reste du substrat 102.

Comme représenté sur la figure 1C, on réalise alors, par exemple par un dépôt PECVD (dépôt chimique en phase vapeur assisté par plasma), sur la face 104, une couche 108 à base de SiN-H, c'est-à-dire du nitrure de silicium riche en hydrogène. Cette couche 108 forme ainsi une couche anti-reflet de la cellule photovoltaïque 100. Cette couche 108 permet également de réaliser la passivation électrique de la face 104.

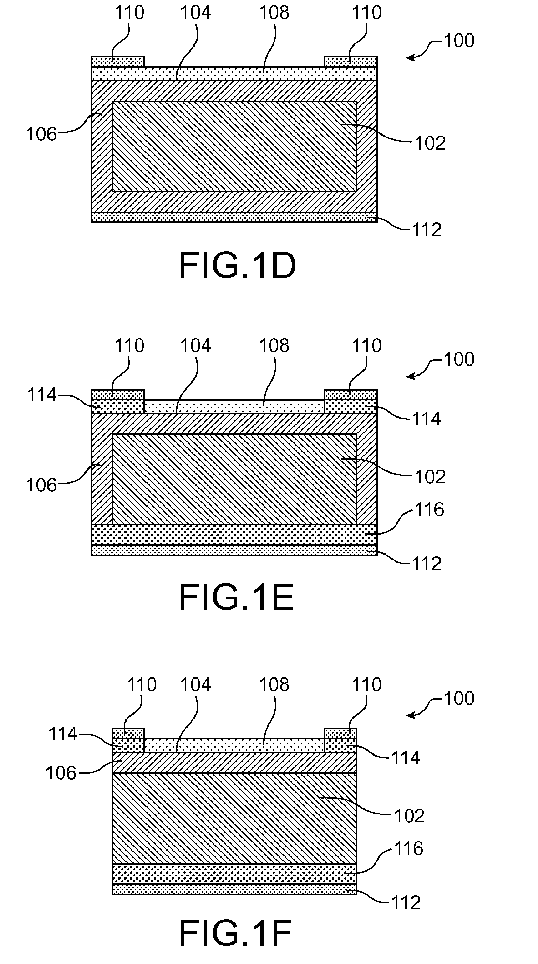

On réalise ensuite des contacts 110 en face avant de la cellule photovoltaïque 100. Ces contacts conducteurs 110 peuvent être obtenus en déposant une couche métallique, par exemple à base d'argent, sur la couche 108, puis en réalisant une sérigraphie de cette couche d'argent. Un contact conducteur arrière 112, ici formé par une couche métallique par exemple à base d'aluminium, est également réalisé sur la face arrière de la cellule photovoltaïque 100 (figures 1D).

Un recuit des contacts 110 et 112, par exemple à une température comprise entre environ 700°C et 900°C, pendant une durée comprise entre environ 1 seconde et 10 minutes, et ici dans un four à lampe infrarouge, permet la prise des contacts avant 110 et arrière 112 avec le silicium. Cette prise de contact correspond à la formation de zones conductrices 114 à base d'argent et de silicium entre les contacts avant 110 et la couche dopée N+ 106, et d'une zone conductrice 116 à base d'aluminium et de silicium entre le contact arrière 112 et le substrat 102 servant de champ de surface arrière (BSF) et permettant le piégeage d'impuretés grâce à l'effet getter par ségrégation développé par l'alliage d'aluminium et de silicium présent en face arrière. De plus, étant donné que la couche 108 est à base de SiN-H, ce recuit réalise également une diffusion d'atomes d'hydrogène depuis la couche 108 dans le substrat 102, permettant de passiver les impuretés métalliques se trouvant dans le substrat 102 (figure 1E).

Enfin, comme représenté sur la figure 1F, on réalise une ouverture de la jonction PN formée par le substrat 102 et la couche 106 dopée N+ en gravant notamment les portions de la couche 106 ne se trouvant pas au niveau de la face avant de la cellule photovoltaïque 100. Cette ouverture peut être réalisée par gravure laser, plasma, enrobage, ou tout autre moyen de gravure.

Au cours de ce procédé de réalisation de la cellule photovoltaïque 100, par exemple entre deux étapes de ce procédé, on met en oeuvre un procédé de traitement du substrat 102 afin de réaliser l'activation thermique des éléments légers présents dans le substrat 102. Dans l'exemple décrit ici, quatre types d'éléments légers sont présents dans le substrat 102 : de l'azote, des composés formés d'azote et d'oxygène, de l'hydrogène et de l'oxygène.

On réalise tout d'abord un premier recuit à une température T1 afin de réaliser l'activation thermique des éléments légers dont la température d'activation est la plus élevée. Dans l'exemple décrit ici, c'est l'azote qui a la température d'activation la plus élevée, celle-ci étant comprise entre environ 530°C et 830°C. Ce premier recuit est par exemple réalisé à une température T1 égale à environ 680°C.

Un second recuit est alors réalisé à une température T2 afin de réaliser l'activation thermique des éléments légers dont la température d'activation est la seconde plus élevée tel que T2 < T1. Il s'agit ici des composés d'azote et d'oxygène dont l'activation thermique peut être réalisée à une température comprise entre environ 450°C et 750°C. Ce second recuit est par exemple réalisé à une température T2 égale à environ 600°C.

Un troisième recuit est ensuite réalisé à une température T3 afin de réaliser l'activation thermique des éléments légers dont la température d'activation est la troisième plus élevée tel que T3 < T2. Il s'agit ici de l'hydrogène dont l'activation thermique peut être réalisée à une température comprise entre environ 350°C et 650°C. Ce troisième recuit est donc par exemple réalisé à une température T3 égale à environ 500°C.

Enfin, un quatrième recuit est réalisé à une température T4 afin de réaliser l'activation thermique des éléments légers dont la température d'activation est la moins élevée. Il s'agit ici de l'oxygène dont l'activation thermique peut être réalisée à une température comprise entre environ 300°C et 600°C. Ce quatrième recuit est donc par exemple réalisé à une température T4 égale à environ 450°C.

Le procédé pour activer thermiquement les éléments légers présents dans le substrat consiste donc ici en une succession de recuits dont les températures sont à chaque fois décroissantes par rapport au recuit précédent. On a donc bien ici T1 > T2 > T3 > T4. De plus, la durée de chaque recuit est adaptée en fonction de la concentration des éléments légers dans le substrat. Plus cette concentration est élevée, plus la durée du recuit, c'est-à-dire la durée du maintien aux températures T1, T2, T3 ou T4, est importante afin d'activer thermiquement le plus d'éléments légers possible. Chaque recuit peut par exemple être réalisé pendant une durée comprise entre quelques minutes et quelques heures, cette durée étant par exemple supérieure ou égale à environ 10 minutes ou 30 minutes. Les durées pendant lesquelles le substrat est maintenu aux températures des recuits sont choisies en fonction des concentrations initiales du substrat en éléments légers qui doivent être activés thermiquement, mais également de la présence d'autres éléments chimiques qui peuvent former des catalyseurs de la réaction d'activation thermique (comme par exemple les éléments hydrogène lors de l'activation thermique des éléments oxygène). Les concentrations en oxygène interstitiel peuvent par exemple être mesurées par spectrométrie FTIR (spectrométrie infrarouge à transformée de Fourier). Les concentrations en hydrogène peuvent être mesurées par spectrométrie SIMS (spectrométrie de masse d'ions secondaires). Les concentrations en éléments C, N, O et S peuvent en outre être mesurées par analyse IGA (sous gaz inerte).

Les exemples de températures donnés ici le sont à titre indicatif. Il est possible, afin d'accélérer l'activation thermique, et donc réduire la durée des recuits, de réaliser ces recuits à des températures plus élevées. Les températures auxquelles sont réalisés les recuits doivent toutefois rester dans une certaine gamme afin de réaliser l'activation thermique des éléments, et ne pas dépasser certains seuils au risque de désactiver le caractère donneur des éléments. Dans l'exemple donné ici, on peut réaliser le premier recuit d'activation thermique de l'azote à une température T1 égale à environ 830°C, le second recuit d'activation thermique des composés d'azote et d'oxygène à une température T2 égale à environ 750°C, le troisième recuit d'activation thermique de l'hydrogène à une température T3 égale à environ 650°C, et enfin le quatrième recuit d'activation thermique de l'oxygène à une température T4 égale à environ 600°C. De plus, lorsque l'oxygène est l'espèce majoritairement présente dans le substrat par rapport aux autres éléments légers, la durée du quatrième recuit peut être supérieure à la durée des autres recuits.

Etant donné que l'hydrogène agit comme un catalyseur à l'activation thermique de l'oxygène, les recuits d'activation thermique peuvent avantageusement être mis en oeuvre après l'étape de dépôt de la couche 108 de SiN-H, et notamment après l'étape de recuit des contacts 110 et 112 compte tenu de la présence d'hydrogène dans le substrat diffusé depuis la couche 108 lors du recuit des contacts 110 et 112, cet hydrogène pouvant être également activé thermiquement.

Dans une variante, les recuits d'activation thermique peuvent également être réalisés avant l'étape de texturation de la face 104 du substrat 102, c'est-à-dire réalisés sur le substrat 102 avant toutes autres étapes liées à la réalisation de la cellule photovoltaïque 100. Dans une autre variante, les recuits peuvent être réalisés sur le lingot de semi-conducteur utilisé pour la réalisation du substrat 102, c'est-à-dire avant même que le substrat 102 ne soit réalisé en coupant une tranche dans le lingot.

Enfin, dans une autre variante, les recuits peuvent également être réalisés une fois que la cellule photovoltaïque 100 est achevée, par exemple après l'étape d'ouverture de la jonction de la cellule 100.

L'effet de l'activation thermique du caractère donneur des éléments légers sur la durée de vie τ des porteurs de charges va maintenant être décrit plus en détail.

Les impuretés dopantes présentes dans le substrat, comme le bore et le phosphore, introduisent des niveaux en énergie dans la bande interdite du silicium situés au voisinage des bandes de valence (pour le bore) et de conduction (pour le phosphore). Ces niveaux en énergie peuvent permettre la recombinaison des charges libres, et donc diminuer la durée de vie τ des charges libres et ainsi que leur longueur de diffusion L. Or, le pouvoir recombinant d'un niveau en énergie situé près des bandes de valence ou de conduction dépend de la position du niveau de Fermi ou de la résistivité. Le pouvoir recombinant d'un niveau d'énergie diminue lorsque le niveau de Fermi se rapproche du milieu de la bande interdite, donc lorsque la résistivité augmente.

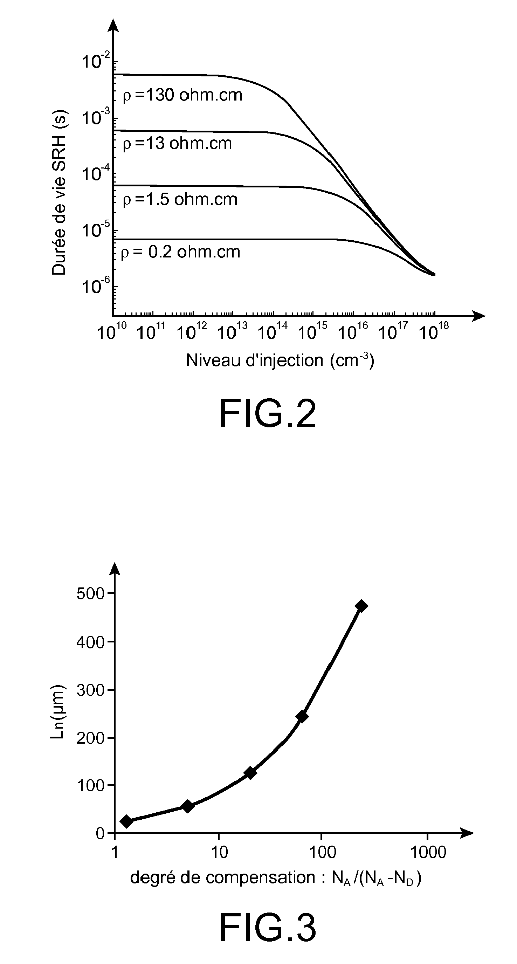

La figure 2 représente l'effet de la résistivité sur l'évolution de la durée de vie des charges libres en fonction du niveau d'injection, calculée à partir de la statistique de Schockley-Read-Hall (SRH), pour un niveau d'énergie situé à 0,1 eV de la bande de conduction. La concentration du centre de recombinaison est de 10¹³ cm⁻³, et ses sections efficaces de capture pour les électrons et les trous sont égales à environ 10⁻¹⁴ cm².

Ainsi, pour une concentration en bore donnée, la longueur de diffusion augmente lorsque l'on vient compenser le bore présent dans le silicium par une autre impureté dopante à caractère donneur. La figure 3, qui représente un résultat de simulation montrant que pour une concentration en bore donnée (ici 3.10¹⁷ cm⁻³), la longueur de diffusion augmente lorsque le degré de compensation du bore augmente (le degré de compensation étant N_{A}/N_{A}-N_{D}), avec N_{A} la concentration en centres accepteurs, et N_{D} la concentration en centres donneurs d'électrons).

Ainsi lorsque du bore est présent à forte concentration, il est judicieux d'augmenter le degré de compensation du matériau, afin d'augmenter les longueurs de diffusion et par conséquent le rendement de conversion des cellules. Ceci est également vrai lorsque le bore est remplacé par une autre impureté qui a un comportement accepteur dans le silicium, par exemple de l'aluminium, du galium, ou encore de l'indium.

Ce degré de compensation peut être augmenté via l'activation thermique du caractère donneur des éléments légers dans le silicium.

L'activation thermique des éléments donneurs est donc confirmée par une mesure de résistivité du matériau semi-conducteur.

Les recuits d'activation peuvent se faire dans des fours à tube, en étuve, dans des fours à passage, via des recuits rapides dans des fours à lampe. L'éclairement des plaquettes de silicium lors du recuit peut aussi faciliter la formation des donneurs thermiques. C'est notamment le cas des donneurs thermiques associant l'oxygène. En effet la formation de ces complexes implique la diffusion de dimères d'oxygènes. Or, la diffusion de ce dernier est plus rapide lorsque la plaquette est éclairée (diffusion via un mécanisme de Bourgoin-Corbett).

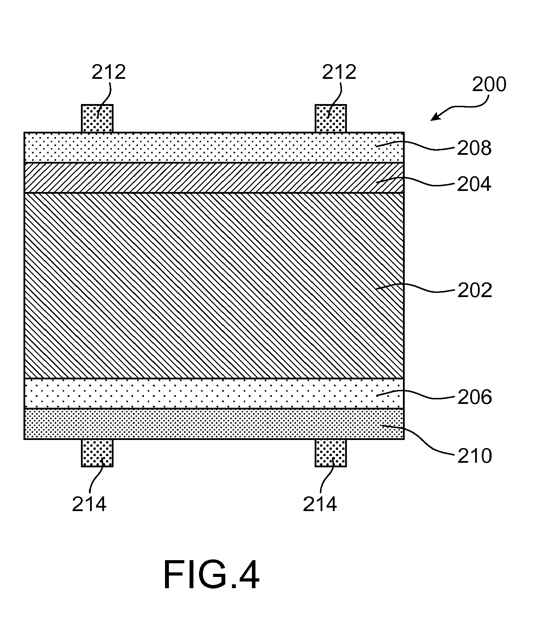

Un substrat à éléments légers activés thermiquement peut également servir à la réalisation d'une cellule photovoltaïque à hétérojonction comme par exemple la cellule 200 représentée sur la figure 4.

Cette cellule 200 est réalisée à partir d'un substrat 202 ici à base de semi-conducteur cristallin (monocristallin ou multicristallin) tel que du silicium de type p purifié par voie métallurgique ou par voie chimique dégradée, c'est-à-dire comportant des concentrations importantes en impuretés dopantes et d'éléments légers.

Pour réaliser la cellule photovoltaïque 200, on réalise tout d'abord une texturation des surfaces du substrat 202, puis un nettoyage spécifique de ces surfaces et un traitement à l'acide fluorhydrique. On réalise ensuite un dépôt, par exemple de type PECVD, de couches de silicium amorphe 204 et 206 respectivement sur la face avant et sur la face arrière du substrat 202. Les couches de silicium amorphe 204 et 206 sont respectivement de type n et de type p. On réalise ainsi une jonction PN entre la couche de silicium amorphe 204 et le substrat de silicium cristallin 202 et la couche de silicium amorphe 206.

Des couches d'oxyde transparent conducteur, par exemple à base d'ITO (oxyde d'indium et d'étain) 208 et 210 sont ensuite déposées respectivement sur les couches de silicium amorphes 204 et 206, par exemple par pulvérisation, évaporation sous vide, LPCVD (dépôt chimique en phase vapeur sous pression réduite), ou encore PECVD (dépôt chimique en phase vapeur assisté par plasma). Enfin, des contacts métalliques 212 et 214 sont respectivement réalisés au niveau de la face avant de la cellule photovoltaïque 200, c'est-à-dire sur la couche d'oxyde transparent conducteur 208, et au niveau de la face arrière de la cellule photovoltaïque 200, c'est-à-dire sur la couche d'oxyde transparent conducteur 210, par exemple par sérigraphie d'une pâte conductrice et recuit à basse température (par exemple égale à environ 200°C).

Ces étapes de réalisation de la cellule photovoltaïque 200 à hétérojonction se font à basses températures (par exemple inférieures à environ 400°C). Le traitement du substrat tel que décrit précédemment, permettant de réaliser l'activation thermique des éléments légers présents dans le substrat 202, pouvant faire intervenir des températures supérieures à environ 400°C, celui-ci peut donc être mis en oeuvre au départ du procédé, sur le lingot de silicium utilisé pour la réalisation du substrat 202 ou directement sur le substrat 202, c'est-à-dire avant l'étape de texturation, ou entre l'étape de texturation et l'étape de nettoyage, ou entre l'étape de nettoyage et l'étape de traitement à l'acide fluorhydrique, ou entre l'étape de traitement à l'acide fluorhydrique et l'étape de dépôt des couches de silicium amorphe 204, 206.

On décrit ci-dessous la mise en oeuvre du procédé de traitement sur un substrat à base de silicium monocristallin comportant initialement une concentration en bore égale à environ 9.10¹⁶ cm⁻³ et une concentration en phosphore égale à environ 8.10¹⁶ cm⁻³, c'est-à-dire ici du silicium de type p dont la concentration en trous est égale à environ 1.10¹⁶ cm⁻³. La concentration initiale en oxygène est égale à environ 10¹⁸ cm⁻³ et les concentrations initiales en hydrogène, fluore et azote sont toutes les trois égales à environ 10¹⁶ cm⁻³.

Un premier recuit est réalisé à une température égale à environ 700°C, cette température étant maintenue sensiblement constante pendant une durée égale à environ 30 mn. Ce premier recuit permet de créer environ 10¹⁵ cm⁻³ composés donneurs d'électrons à base de fluore. Un second recuit est réalisé à une température égale à environ 680°C, cette température étant maintenue sensiblement constante pendant une durée égale à environ 90 mn. Ce second recuit permet de créer environ 10¹⁵ cm⁻³ éléments donneurs d'électrons à base d'azote. Un troisième recuit est réalisé à une température égale à environ 450°C, cette température étant maintenue sensiblement constante pendant une durée égale à environ 5 heures. Ce troisième recuit permet de créer environ 10¹⁵ cm⁻³ éléments donneurs d'électrons à base d'oxygène. Enfin, un quatrième recuit est réalisé à une température égale à environ 300°C, cette température étant maintenue sensiblement constante pendant une durée égale à environ 20 mn. Ce quatrième recuit permet de créer environ 10¹⁵ cm⁻³ éléments donneurs à base d'hydrogène.

Ces quatre recuits ont donc permis de créer dans le substrat une concentration totale en éléments donneurs d'électrons égale à environ 4.10¹⁵ cm⁻³. La concentration en trous dans le substrat à l'issu des quatre recuits est donc égale à environ 6.10¹⁵ cm⁻³.

## Revendications

1. Procédé de traitement d'un substrat (102, 202) à base d'au moins un semi-conducteur de type Si_{X}A_{Y}, x étant un nombre strictement positif, y étant un nombre positif et A désignant un élément chimique ou un composé de plusieurs éléments chimiques de la quatorzième colonne du tableau périodique des éléments, et comportant au moins quatre types distincts d'éléments légers, le procédé comprenant au moins les étapes suivantes :
- réalisation d'un premier recuit du substrat (102, 202) à une température T1 correspondant à une température d'activation thermique d'un premier des quatre types d'éléments légers,
- réalisation, après le premier recuit, d'un second recuit du substrat (102, 202) à une température T2 correspondant à une température d'activation thermique d'un second des quatre types d'éléments légers,
- réalisation, après le second recuit, d'un troisième recuit du substrat (102, 202) à une température T3 correspondant à une température d'activation thermique d'un troisième des quatre types d'éléments légers,
- réalisation, après le troisième recuit, d'un quatrième recuit du substrat (102, 202) à une température T4 correspondant à une température d'activation thermique d'un quatrième des quatre types d'éléments légers,
chaque recuit comportant un maintien à la température T1, T2, T3 ou T4 pendant une durée déterminée, et les températures T1, T2, T3 et T4 étant telles que T1 > T2 > T3 > T4.

2. Procédé de traitement selon la revendication 1, dans lequel le semi-conducteur est du silicium cristallin de type p.

3. Procédé de traitement selon l'une des revendications précédentes, dans lequel chacun des quatre types d'éléments légers présents dans le semi-conducteur est soit de l'oxygène, de l'azote, du carbone, de l'hydrogène, du fluor, du souffre, du chlore, un composé d'azote et d'oxygène, au d'autres composés entre ces éléments.

4. Procédé de traitement selon l'une des revendications précédentes, dans lequel T1 est comprise entre environ 530°C et environ 830°C, et/ou T2 est comprise entre environ 450°C et 750°C, et/ou T3 est comprise entre environ 350°C et 650°C, et/ou T4 est comprise entre environ 300°C et 600°C.

5. Procédé de traitement selon l'une des revendications précédentes, dans lequel T1 est égale à environ 680°C, et/ou T2 est égale à environ 600°C, et/ou T3 est égale à environ 500°C, et/ou T4 est égale à environ 450°C.

6. Procédé de traitement selon l'une des revendications précédentes, comportant en outre, après la réalisation du quatrième recuit, la réalisation d'un cinquième recuit à une température T5 correspondant à une température d'activation thermique d'un cinquième type d'éléments légers présents dans le semi-conducteur distinct des quatre autres types d'éléments légers présents dans le semi-conducteur, avec T5 < T4.

7. Procédé de traitement selon la revendication 6, comportant en outre, après la réalisation du cinquième recuit, la réalisation d'un sixième recuit à une température T6 correspondant à une température d'activation thermique d'un sixième type d'éléments légers présents dans le semi-conducteur distinct des cinq autres types d'éléments légers présents dans le semi-conducteur, avec T6 < T5.

8. Procédé de traitement selon la revendication 7, comportant en outre, après la réalisation du sixième recuit, la réalisation d'un septième recuit à une température T7 correspondant à une température d'activation thermique d'un septième type d'éléments légers présents dans le semi-conducteur distinct des six autres types d'éléments légers présents dans le semi-conducteur, avec T7 < T6.

9. Procédé de traitement selon la revendication 8, comportant en outre, après la réalisation du septième recuit, la réalisation d'un huitième recuit à une température T8 correspondant à une température d'activation thermique d'un huitième type d'éléments légers présents dans le semi-conducteur distinct des sept autres types d'éléments légers présents dans le semi-conducteur, avec T8 < T7.

10. Procédé de traitement selon l'une des revendications précédentes, dans lequel au moins l'un des recuits est réalisé dans un four à lampe dans lequel est disposé le substrat (102, 202) à base de semi-conducteur.

11. Procédé de traitement selon l'une des revendications précédentes, dans lequel au moins l'un des recuits est réalisé sous atmosphère d'oxygène et/ou d'azote et/ou d'hydrogène et/ou d'argon et/ou d'hélium.

12. Procédé de traitement selon l'une des revendications précédentes, dans lequel les recuits sont réalisés sur un lingot du semi-conducteur, le substrat (102, 202) étant ensuite obtenu par une coupe d'une tranche du lingot.

13. Procédé de réalisation d'un dispositif semi-conducteur (100, 200) à partir d'un substrat (102, 202) à base d'au moins un semi-conducteur de type Si_{X}A_{Y}, x étant un nombre strictement positif, y étant un nombre positif et A désignant un élément chimique ou un composé de plusieurs éléments chimiques de la quatorzième colonne du tableau périodique des éléments, et comportant au moins quatre types distincts d'éléments légers, comportant au moins la mise en oeuvre du procédé de traitement du substrat (102, 202) selon l'une des revendications 1 à 12.

14. Procédé selon la revendication 13, dans lequel le dispositif semi-conducteur (100, 200) comporte au moins une cellule photovoltaïque.

15. Procédé selon la revendication 14, dans lequel le substrat (102) est à base de silicium cristallin de type p, le procédé de réalisation du dispositif semi-conducteur (100) comportant en outre les étapes suivantes :
- texturation d'au moins une première face (104) du substrat (102) destinée à former une face avant de la cellule photovoltaïque,
- formation d'une couche dopée N+ (106) au niveau des faces du substrat (102),
- dépôt d'une couche (108) de passivation et/ou anti-reflet sur la couche dopée N+ (106), au niveau de la première face (104) du substrat (102),
- réalisation de contacts conducteurs (110, 112) sur la couche (108) de passivation et/ou anti-reflet et sur la couche dopée N+ (106), au niveau d'une seconde face, opposée à la première face (104), du substrat (102),
- recuit des contacts conducteurs (110, 112),
- gravure de la couche dopée N+ (106) au niveau des faces du substrat sensiblement perpendiculaires à la première (104) et à la seconde face du substrat (102),
les étapes du procédé de traitement du substrat (102) étant mises en oeuvre avant l'étape de texturation, et/ou après l'étape de gravure, et/ou entre deux étapes du procédé de réalisation du dispositif semi-conducteur (100).

16. Procédé selon la revendication 14, le substrat (202) étant à base de silicium cristallin de type p, le procédé de réalisation du dispositif semi-conducteur (200) comportant en outre au moins une étape de dépôt d'une couche de silicium amorphe (204, 206) sur deux faces opposées du substrat (200) destinées à former les faces avant et arrière de la cellule photovoltaïque, les étapes du procédé de traitement du substrat (202) étant mises en oeuvre avant cette étape de dépôt.
